(19) **Europäisches Patentamt / European Patent Office / Office européen des brevets**

(11) **EP 2 513 997 B1**

(12) **FASCICULE DE BREVET EUROPEEN**

(45) Date de publication et mention
de la délivrance du brevet:
**02.04.2014 Bulletin 2014/14**

(21) Numéro de dépôt: **10790554.9**

(22) Date de dépôt: **09.12.2010**

(51) Int Cl.:
*H01L 51/52* (2006.01)     *H01L 51/44* (2006.01)
*H01L 31/048* (2014.01)     *B65D 81/05* (2006.01)
*H05B 33/04* (2006.01)

(86) Numéro de dépôt international:
**PCT/EP2010/069235**

(87) Numéro de publication internationale:
**WO 2011/073073 (23.06.2011 Gazette 2011/25)**

(54) **DISPOSITIF D'ENCAPSULATION A ETANCHÉITÉ AMELIORÉE**

VERKAPSELTE VORRICHTUNG MIT VERBESSERTER VERSIEGELUNG

ENCAPSULATION DEVICE HAVING IMPROVED SEALING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.12.2009 FR 0958948**

(43) Date de publication de la demande:
**24.10.2012 Bulletin 2012/43**

(73) Titulaires:
• **Commissariat à l'Énergie Atomique
et aux Énergies Alternatives
75015 Paris (FR)**
• **Université de Savoie
73000 Chambery (FR)**

(72) Inventeurs:
• **CROS, Stéphane**
**F-73000 Chambéry (FR)**
• **ALBEROLA, Nicole**
**F-73000 Chambéry (FR)**
• **GARANDET, Jean-Paul**
**F-73370 Le Bourget du Lac (FR)**
• **MORLIER, Arnaud**
**F-74130 Faucigny (FR)**

(74) Mandataire: **Ilgart, Jean-Christophe
BREVALEX
95, rue d'Amsterdam
75378 Paris Cedex 8 (FR)**

(56) Documents cités:
**WO-A2-2007/098021     WO-A2-2008/112239
US-A- 5 272 856     US-A1- 2008 264 473**

**Description**

**DOMAINE TECHNIQUE ET ART ANTÉRIEUR**

La présente invention se rapporte à un dispositif d'encapsulation à étanchéité améliorée, par exemple destiné à l'encapsulation de cellules photovoltaïques organiques et un ensemble formé d'un tel dispositif d'encapsulation et d'un dispositif, tel qu'une cellule photovoltaïque, encapsulé dans ledit dispositif.

Les cellules solaires organiques comportent un polymère organique semi-conducteur associé à des électrodes métalliques. Ces cellules présentent notamment l'avantage d'offrir une certaine souplesse mécanique et d'être d'un coût réduit par rapport aux cellules photovoltaïques cristallines ou polycristallines en silicium, notamment du fait de leur procédé de réalisation.

Cependant, elles présentent l'inconvénient d'être sensibles à l'humidité et à l'oxygène. Si elles ne sont pas correctement protégées, leur durée de vie est réduite. Il est donc souhaitable de les protéger de l'humidité et de l'oxygène.

Il existe plusieurs techniques connues pour réaliser une telle encapsulation.

Une des techniques décrite dans le document Krebs F. et al, *Solar Energy Materials and Solar Cells* 90(2006) 3633-3643 consiste à disposer une cellule photovoltaïque entre deux capots, et de sceller les deux capots par un joint. Plus particulièrement dans le document cité ci-dessus, l'un des capots est une plaque de verre, l'autre est une plaque d'aluminium et le joint est en matériau époxy renforcé en fibres de verre. Cette encapsulation, pour être effectivement suffisamment étanche à l'humidité et à l'oxygène, doit utiliser une plaque de verre épaisse. D'une part, l'ensemble ainsi formé a une masse non négligeable. D'autre part, il n'offre plus la souplesse de la cellule encapsulée. Et enfin, cette technique est limitée à de petites surfaces.

Il existe également une technique consistant en enfermer une diode électroluminescente organique entre deux couches de polymère organique recouvertes de couches denses d'oxyde métallique, le polymère organique à lui seul étant perméable au gaz. Ces couches d'oxyde métallique sont déposées par évaporation sous vide. Cette technique requiert donc des équipements coûteux, ce qui va à l'encontre d'une réduction du coût de fabrication de cellules photovoltaïques. Cette technique est décrite dans le document Burrows P. and al., *Ultra Barrier flexible Susbstrates for flat panel displays*, dans *Displays* 22 (2001) 65-69.

Il existe également une technique consistant à disposer une cellule photovoltaïque dans un boîtier étanche et à remplir le boîtier d'huile, noyant ainsi la cellule dans l'huile. L'huile, dans laquelle la cellule est immergée, forme pour la cellule baignant dans celle-ci, une barrière à l'humidité grâce à ses propriétés hydrophobes et une barrière à l'oxygène. Cependant, il existe un risque de solubilisation des polymères organiques utilisés pour réaliser les cellules dans l'huile, et de ce fait un risque de dégradation de la cellule. Le document US 5,272,856 décrit un dispositif en forme d'enveloppe pour protéger un objet lors du transport, l'enveloppe comprenant un compartiment rempli d'eau ou de gaz·

C'est par conséquent un but de la présente invention d'offrir un dispositif d'encapsulation d'un ou plusieurs dispositifs à protéger, par exemple des cellules photovoltaïques, protégeant efficacement le ou les dispositifs de l'humidité et de l'oxygène, et plus généralement des gaz.

C'est également un but de la présente invention d'offrir un dispositif d'encapsulation de conception simple, de faible masse et permettant de conserver les propriétés de souplesse

**EXPOSÉ DE L'INVENTION**

Les buts précédemment énoncés sont atteints par un dispositif d'encapsulation comportant au moins une paroi destinée à délimiter un espace intérieur étanche dans lequel est disposé le dispositif à protéger ou objet, la cloison étant formée d'une enveloppe souple en polymère remplie d'un liquide hydrophobe.

En d'autres termes, on réalise un contenant souple dont la paroi est constituée d'huile confinée, cette huile étant isolée du contenu.

Selon l'invention, le dispositif à protéger est protégé de l'humidité et de l'atmosphère par la barrière d'huile, sans être en contact avec celle-ci. Par ailleurs, l'huile est suffisamment transparente aux rayons lumineux pour ne pas perturber le bon fonctionnement du dispositif, dans le cas où celui-ci est une cellule photovoltaïque.

De plus, la masse du dispositif d'encapsulation est réduite, puisque celui-ci ne comporte que de l'huile et l'enveloppe en polymère souple relativement fine.

La présente invention a alors principalement pour objet un ensemble **selon la revendication 1**.

La au moins une enveloppe peut comporter une première feuille en matériau polymère et une deuxième feuille en matériau polymère reliées l'une à l'autre au niveau de leurs bords extérieurs de sorte à définir un volume étanche au matériau hydrophobe entre les deux feuilles.

L'ensemble peut comporter deux enveloppes en matériau polymère souple délimitant chacune un espace étanche au matériau hydrophobe, et au moins un matériau hydrophobe remplissant chacune desdites enveloppes, lesdites enveloppes étant superposées et reliées l'une à l'autre au niveau de leurs bords périphériques de manière étanche, un espace étanche étant alors défini entre les deux enveloppes.

L'angle de contact d'une goutte de liquide du matériau hydrophobe sur la surface intérieure de la au moins une enveloppe peut être inférieur à 60°, avantageusement inférieur à 30°, et de manière encore plus avantageuse inférieur à 10°.

L'énergie d'adhésion du matériau hydrophobe sous forme liquide sur la surface intérieure de l'enveloppe peut être supérieure à 0,03 J/m$^2$, de manière préférée supérieure à 0,045 J/m$^2$,

Le matériau hydrophobe peut présenter une solubilité de l'eau inférieure ou égale à 10$^{-3}$ (fr.mol), avantageusement inférieure ou égale à 10$^{-4}$ (fr.mol).

Avantageusement, le matériau hydrophobe sous forme liquide présente une viscosité supérieure ou égale à 10$^{-3}$ Pa.s.

Le matériau hydrophobe sous forme liquide confiné dans la au moins une enveloppe présente par exemple une épaisseur comprise entre 5 $\mu$m et 5 mm. L'épaisseur de la paroi de au moins une enveloppe peut être comprise entre 10 $\mu$m et 500 $\mu$m.

L'enveloppe peut être réalisée en polycarbonate, en polyéthylène (PE), en polyéthylène téréphtalate (PET), en polyéthylène naphtalate (PEN), en copolymère éthylène-acétate de vinyle (EVA) ou en polyvinylalcool (PVA).

Par exemple, le matériau hydrophobe est une huile minérale, une huile silicone, une huile paraffine, une huile naturelle, un acide gras ou un ester à longue chaîne alkyle, ou un alcane tel qu'un alcane des séries C$_{12}$H$_{26}$ à C$_{16}$H$_{34}$.

L'objet encapsulé dans un ensemble selon la présente invention, étant par exemple une cellule photovoltaïque ou une diode électroluminescente organique.

La présente invention a également pour objet un procédé de réalisation d'un ensemble selon la présente invention, comportant les étapes de :

> a) réalisation d'une enveloppe en polymère souple dans laquelle est disposé le matériau hydrophobe,
> b) scellement de l'enveloppe de manière étanche.

Dans un exemple, l'étape a) comprend la réalisation d'une enveloppe en polymère souple munie d'une ouverture et le remplissage de l'enveloppe avec un matériau hydrophobe. L'étape a) peut comporter la superposition de deux feuilles de polymère souple de tailles proches ou égales, de sorte que leurs bords périphériques soient sensiblement alignés et la solidarisation des bords périphériques de manière étanche sauf sur une portion, ménageant ainsi une ouverture de remplissage.

Préalablement à l'étape b), on recouvre avantageusement au moins les bords de l'ouverture de remplissage d'un matériau oléophobe.

Dans un autre exemple, lors de l'étape a), on recouvre les bords d'une ou des feuilles de l'enveloppe d' un matériau oléophobe, on enduit l'une des feuilles avec le matériau hydrophobe.

Dans un autre exemple, préalablement à l'étape a), le matériau hydrophobe est solidifié par abaissement de la température et mis en forme de bloc et, lors de l'étape a) l'enveloppe est formée autour dudit bloc solide. Par exemple, le matériau hydrophobe est du tétradécane.

De préférence le bloc solide présente des surfaces convexes.

La liaison des feuilles et/ou la fermeture de l'ouverture de remplissage est obtenue par exemple par thermosoudage ou par collage.

BRÈVE DESCRIPTION DES DESSINS

La présente invention sera mieux comprise à l'aide de la description qui va suivre et des dessins en annexe sur lesquels :

- la figure 1 est une vue en coupe schématique d'un dispositif d'encapsulation selon la présente invention,
- la figure 2 est une vue d'un élément du dispositif de la figure 1,
- les figures 3A et 3B sont des exemples de forme de bloc en matériau hydrophobe utilisé dans un exemple d'un procédé de réalisation selon la présente invention,
- les figures 4 à 6 sont des représentations schématiques de variante de réalisation d'un dispositif d'encapsulation selon la présente invention.

**EXPOSÉ DÉTAILLÉ DE MODES DE RÉALISATION PARTICULIERS**

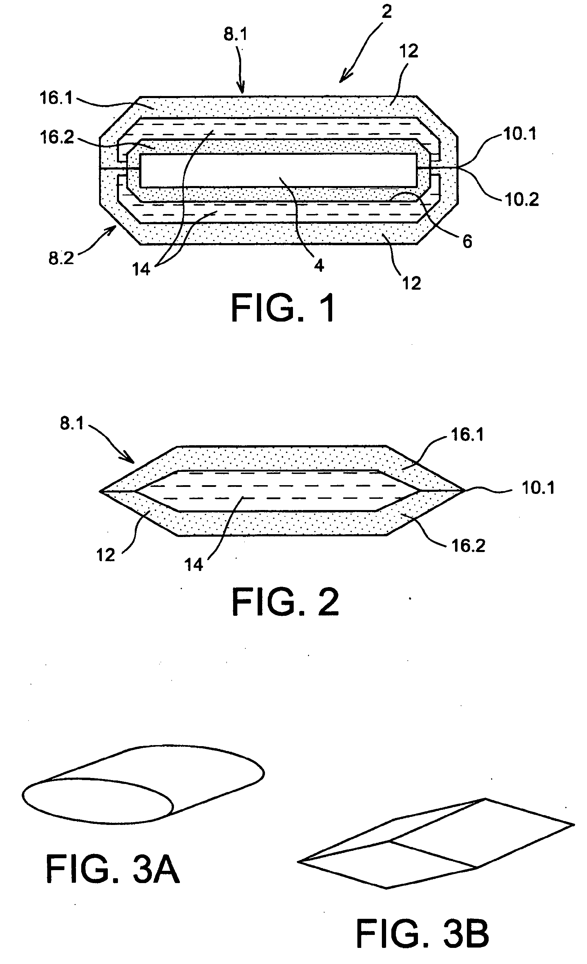

Sur la figure 1, on peut voir un exemple de réalisation d'un dispositif d'encapsulation 2 selon la présente invention à l'intérieur duquel est disposé un dispositif à encapsuler 4, par exemple une cellule photovoltaïque.

Le dispositif d'encapsulation 2 comporte un espace intérieur étanche 6 recevant le dispositif à encapsuler 4.

Dans l'exemple représenté, le dispositif à encapsuler 4, telle qu'une cellule photovoltaïque, présente une épaisseur faible par rapport à sa surface, l'exemple du dispositif d'encapsulation 2 représenté sur la figure 1 présente une forme adaptée à la forme de la cellule photovoltaïque.

Le dispositif d'encapsulation 2 comporte alors deux parois 8.1, 8.2 disposées l'une au-dessus de l'autre et reliées de manière étanche sur tout leur contour extérieur 10.1, 10.2. Les deux parois 8.1, 8.2 ainsi reliées délimitent l'espace étanche 6 dans lequel est disposé le dispositif à encapsuler 4. Dans la représentation de la figure 1, la paroi 8.1 recouvre la face supérieure du dispositif à encapsuler 4 et la paroi 8.2 recouvre la paroi inférieure du dispositif à encapsuler 4.

Chaque paroi 8.1, 8.2 comporte une enveloppe en polymère souple étanche 12 et un matériau hydrophobe 14 remplissant l'enveloppe 12. Sur la figure 2, seule la paroi 8.1 est représentée.

On entend par matériau hydrophobe un matériau présentant une mauvaise affinité avec l'eau.

Le matériau hydrophobe est choisi de sorte qu'il soit sous forme liquide à la température de fonctionnement, plus généralement qu'il soit liquide à température ambiante afin de limiter la diffusion des éléments perméants, i.e. pouvant traverser l'enveloppe en polymère .Par ailleurs, cela permet de disposer de dispositifs encapsulés conservant leur souplesse, tels que les cellules photovoltaïques organiques. Il en résulte que le choix du matériau hydrophobe pourra dépendre des températures de l'environnement dans lequel les dispositifs encapsulés seront destinés à être utilisés.

Dans la suite de la description, nous utiliserons l'expression « liquide hydrophobe » pour désigner le matériau hydrophobe, nous préciserons lorsque le matériau est sous forme solide.

Le liquide hydrophobe remplit l'enveloppe 12 de sorte que celle-ci ne contienne plus d'air ou de gaz qui, sinon, pourrait traverser la feuille de polymère en contact avec le dispositif à encapsuler et risquer de la détériorer.

L'enveloppe 12 est, par exemple formée de deux feuilles de polymères 16.1, 16.2 solidarisées l'une à l'autre par exemple par thermosoudage, délimitant entre elles un volume étanche confinant le liquide hydrophobe 14.

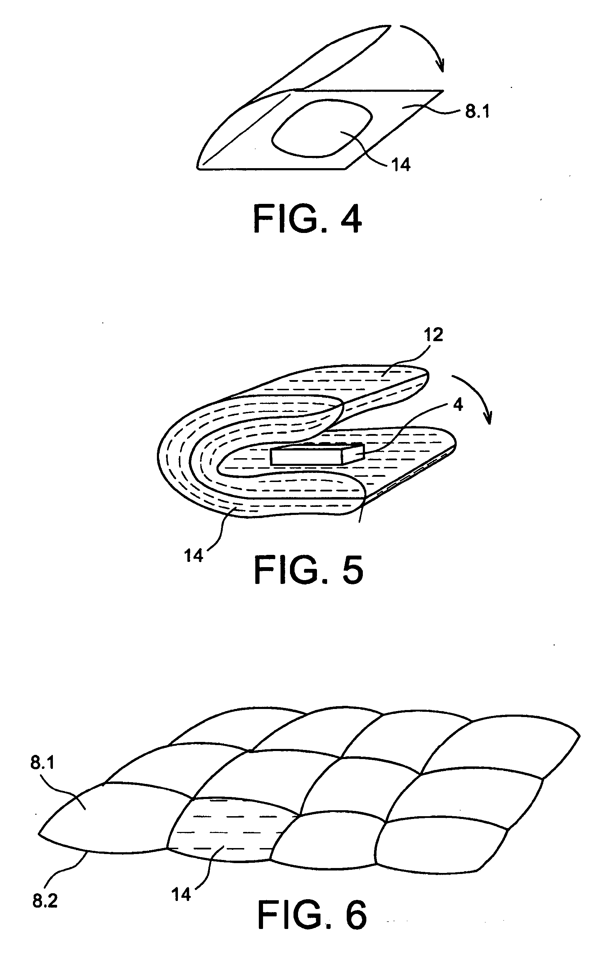

On peut aussi envisager de réaliser es enveloppe 12 en n'utilisant qu'une seule feuille de polymère repliée sur elle-même, le liquide hydrophobe étant situé entre les deux parties repliées de la feuille, comme cela est schématisé sur la figure 4.

On peut également envisager de réaliser le dispositif d'encapsulation à partir d'une paroi de grande taille formée d'une seule enveloppe remplie de liquide hydrophobe, cette grande paroi étant repliée sur le dispositif à encapsuler, comme cela est schématisé sur la figure 5.

On peut également envisager d'utiliser une feuille de polymère plié en quatre. Le premier pliage délimitant l'espace à remplir de liquide hydrophobe et le deuxième pliage délimitant l'emplacement pour le dispositif à encapsuler.

Avantageusement, le liquide hydrophobe 14 et la surface intérieure de l'enveloppe 12 avec laquelle le liquide hydrophobe 14 est en contact, sont choisis de sorte que le liquide hydrophobe présente une bonne mouillabilité vis-à-vis de cette surface intérieure. Cette bonne mouillabilité empêche la formation de bulles de gaz entre le volume de liquide hydrophobe et la paroi de l'enveloppe lors du remplissage de l'enveloppe. A cette effet, l'angle de contact d'une goutte de liquide hydrophobe sur la surface intérieure de l'enveloppe est inférieur à 60°, avantageusement inférieur à 30°, et de manière encore plus avantageuse inférieur à 10°.

Ces valeurs d'angle de contact peuvent être obtenues grâce aux propriétés intrinsèques du polymère ou par le traitement de la surface intérieure de l'enveloppe.

De manière également avantageuse, on choisit le liquide hydrophobe et le polymère et/ou le traitement de la surface intérieure de l'enveloppe de sorte que l'énergie d'adhésion soit supérieure à 0,03 J/m$^2$, de manière préférée supérieure à 0,045 J/m$^2$.

Nous rappelons que l'énergie d'adhésion est donnée par la formule :

$$E_{adhésion} = \sigma \times (1 + \cos\theta)$$

$\sigma$ étant l'énergie interfaciale liquide-vapeur du liquide hydrophobe,

$\theta$ étant l'angle de contact du liquide sur la surface intérieure de l'enveloppe 12.

En choisissant de telles valeurs d'énergie d'adhésion, les risques de démouillage du liquide hydrophobe sont réduits de manière importante, lorsque le dispositif d'encapsulation 2 est déformé, en particulier lorsqu'il contient un dispositif souple. Le liquide hydrophobe reste alors en contact avec toute la surface intérieure de l'enveloppe, ce qui réduit les risques d'entrée d'humidité et de gaz qui peuvent traverser l'enveloppe 12 en polymère. Par conséquent, la souplesse du dispositif peut être largement exploitée sans risque de détériorer la barrière formée par l'huile.

L'épaisseur du film de liquide hydrophobe est avantageusement comprise entre 5 $\mu$m et 5 mm.

De plus, afin d'augmenter encore l'étanchéité à l'humidité des parois du dispositif d'encapsulation 2, on choisit avantageusement un liquide hydrophobe présentant une solubilité minimale vis-à-vis de l'eau. Avantageusement, le liquide hydrophobe présente une solubilité vis-à-vis de l'eau inférieure ou égale à 10$^{-3}$ (fr.mol), encore plus avantageusement inférieure ou égale à 10$^{-4}$ (fr.mol), fr. mol étant la fraction molaire : le nombre de moles d'eau pouvant être solubilisé dans une mole de liquide hydrophobe.

Préférentiellement, on choisit également un liquide hydrophobe présentant une viscosité la plus élevée possible, ce qui permet d'éviter les transports de bulles et de gaz dissous par convection à travers le volume de liquide hydrophobe. La viscosité est de préférence supérieure ou égale à 10$^{-3}$ Pa.s.

Par exemple, le liquide hydrophobe mis en oeuvre peut être une huile minérale, une huile silicone, une huile paraffine, une huile naturelle, un acide gras ou un acide à longue chaîne alkyle. On peut s'agir également d'un alcane. A titre d'exemple, les séries $C_{12}H_{26}$ à $C_{16}H_{34}$ sont particulièrement adaptées.

Les molécules organiques à longue chaîne alkyle tels des esters et acides gras présentent une faible polarité, et donc une faible solubilité de l'eau. En outre, ceux-ci présentent également une viscosité significative.

Le liquide hydrophobe peut être formé d'un seul type de liquide ou un mélange de liquides hydrophobes tels que ceux cités ci-dessus à titre d'exemple.

Dans le cas où le dispositif à encapsuler 4 est une cellule photovoltaïque, l'ensemble de l'enveloppe formant la paroi qui reçoit les rayons incidents (polymère et liquide hydrophobe 14 ou le mélange de liquides hydrophobe) est avantageusement choisi de sorte qu'il assure une transmission au moins égale à 80 % sur tout le domaine du visible.

Le polymère peut être choisi parmi les polycarbonates, le polyéthylène (PE), le polyéthylène téréphtalate (PET), le polyéthylène naphtalate (PEN), le copolymère éthylène-acétate de vinyle (EVA) ou le polyvinylalcool (PVA).

En outre, l'épaisseur de l'enveloppe est avantageusement comprise entre 10 μm et 500 μm, offrant ainsi une rigidité et une ténacité suffisante.

Nous allons maintenant décrire différents exemples de procédé de réalisation d'un dispositif d'encapsulation selon la présente invention.

Selon un premier exemple de procédé de réalisation, chaque enveloppe 12 est réalisée en superposant deux feuilles 16.1, 16.2 en matériau polymère présentant sensiblement les mêmes dimensions, puis en les solidarisant au niveau de leurs bordures extérieures, par exemple par thermosoudage. La thermosoudure ainsi obtenue est étanche. Seule une zone des bordures périphériques n'est pas soudée afin de permettre l'introduction du liquide hydrophobe entre les deux feuilles. Cette zone non soudée forme une ouverture de remplissage.

Le liquide hydrophobe ou un mélange de liquides hydrophobes est ensuite injecté entre les deux feuilles 16.1, 16.2 à travers l'ouverture de remplissage, par exemple à l'aide d'une canule.

Avantageusement, on évacue les bulles d'air restantes par l'ouverture de remplissage. Cette évacuation est obtenue par exemple par pressage.

L'ouverture de remplissage est ensuite fermée par exemple par soudage, avantageusement par thermosoudage ou par collage. Le thermosoudage présente l'avantage d'être simple puisqu'il ne nécessite pas l'application préalable d'une colle.

Avantageusement, on peut prévoir un traitement particulier des parties à souder délimitant l'ouverture de remplissage, pour éviter le dépôt de liquide hydrophobe qui pourrait nuire à la soudure. Par exemple, ce traitement peut consister en un dépôt préalable d'un matériau oléophobe sur les parties à souder. Le terme « oléophobe » qualifie une substance ayant une faible affinité avec les huiles.

Ce traitement peut consister en un dépôt d'un tel matériau oléophobe directement sur les feuilles de polymère de l'enveloppe, ou il peut consister en un collage d'une petite surface d'un autre polymère organique non compatible avec le liquide hydrophobe.

Le matériau oléophobe peut par exemple être un prépolymère organosilane comportant une chaîne pendante perfluoroalkylée réticulable par voie thermique.

Ainsi, lors du remplissage de l'enveloppe avec le liquide hydrophobe, celui-ci ne se dépose pas au niveau de l'ouverture de remplissage du fait de la présence du matériau oléophobe. Les bords restant à souder sont donc exempts du liquide hydrophobe, ce qui facilite la réalisation de la soudure.

On obtient alors une première paroi 8.1.

Une deuxième paroi 8.2 est réalisée suivant le même procédé.

Le dispositif à encapsuler est ensuite placé entre les deux parois dont on aura fait coïncider les bords, puis les bords sont solidarisés de manière étanche, par exemple par thermosoudage.

Par exemple, on effectue l'assemblage sous atmosphère sèche et neutre, supprimant la présence d'humidité et d'air lors de l'encapsulation.

La dernière thermosoudure peut être réalisée sur les premières thermosoudures ce qui permet de ne pas perdre de surface, ou elle est décalée par rapport aux premières thermosoudures.

Par exemple, on effectue la soudure entre deux surfaces.

Selon un deuxième exemple de procédé de réalisation, on effectue un traitement oléophobe préalable au niveau des zones des feuilles à souder, i.e. sur les bords des feuilles. Ce traitement est, par exemple effectué par dépôt direct du matériau sur les feuilles polymère.

On effectue ensuite un dépôt par enduction du liquide hydrophobe sur l'une des feuille, le liquide hydrophobe se positionne naturellement aux endroits exempts du traitement oléophobe, les zones à souder ne sont alors pas contaminées avec le liquide hydrophobe. Le thermosoudage est ensuite réalisé.

On réalise ensuite de la même manière la deuxième paroi et on solidarise les deux parois autour du dispositif à encapsuler.

Selon un troisième exemple de réalisation, on utilise un bloc obtenu à parti du liquide hydrophobe préalablement dégazé et porté à une température inférieure à sa température de fusion.

Le bloc ainsi obtenu est ensuite déposé sur une première feuille en polymère. Une seconde feuille est ensuite plaquée sur la partie non recouverte du bloc de façon à ne pas incorporer de gaz. Les feuilles sont ensuite solidarisées de manière étanche, par exemple par thermosoudage. Une première paroi est alors prête.

Avantageusement, le bloc a une forme permettant un enveloppement aisé sans générer de cavités risquant de piéger de l'air. Par exemple, les blocs présentent des faces convexes.

Sur les figures 3A et3B, on peut voir des exemples de réalisation de tels blocs. Sur la figure 3A, le bloc à la forme d'un cylindre à section elliptique, et sur la figure 3B, le bloc a la forme d'un prisme.

On réalise ensuite une deuxième paroi de manière similaire. Le dispositif à encapsuler est ensuite placé entre les deux parois ainsi réalisées dont on aura fait coïncider les zones soudées. Les bords sont ensuite solidarisés de manière étanche, par exemple par thermosoudage.

A titre d'exemple, on utilise comme matériau hydrophobe du tétradécane dont la température de fusion est 5, 5°C. Celui-ci est mis en forme de bloc à 0°C et est enveloppé entre deux feuilles de polyéthylène téréphtalate (PET). Ensuite, lors de son utilisation à température ambiante, le tétradécane entre en fusion et devient liquide. Le dispositif d'encapsulation devient alors souple.

Dans le cas où le dispositif encapsulé nécessite des connexions électriques, la sortie étanche des connexions électriques vers l'extérieur du dispositif d'encapsulation est réalisée de manière connue par l'homme du métier.

Il est bien entendu que l'on peut prévoir de combiner les étapes des procédés décrits ci-dessus.

Grâce à la présente invention, on tire profit des avantages de la phase liquide comme barrière de diffusion au gaz et des avantages de la propriété hydrophobe comme barrière spécifique à l'humidifié, sans risquer de dégrader le ou les dispositifs encapsulés, par exemple de solubiliser le polymère d'une cellule photovoltaïque due à un contact direct avec le liquide hydrophobe.

Par ailleurs, le dispositif d'encapsulation est facilement manipulable, le liquide hydrophobe étant confiné dans les poches de polymère.

Par ailleurs, la taille du dispositif d'encapsulation est très adaptable à toute taille de tout dispositif à encapsuler.

Grâce à l'invention, il est également possible de mettre en oeuvre divers traitements en fonction de l'application visée, par exemple le dépôt d'une couleur, d'une protection antireflet, d'une protection anti rayures ...) sur les surfaces externes ou internes du dispositif d'encapsulation.

Par ailleurs, grâce à l'invention, il est possible d'assembler très facilement plusieurs dispositifs encapsulés via les dispositifs d'encapsulation, par exemple par thermosoudage ou par collage, et ainsi de former de « nappes souples » de dispositifs encapsulés, ce qui peut être particulièrement intéressant dans le cas des cellules photovoltaïques.

On peut envisager de réaliser plusieurs encapsulations simultanément, en réalisant une pluralité d'enveloppes remplies d'huile à partir de deux feuilles de polymères soudées ou collées en quadrillage, comme cela est schématisé sur la figure 6. En superposant deux enveloppes de ce type, on peut obtenir directement des cellules encapsulées sous forme de nappe.

En outre, le dispositif d'encapsulation selon la présente invention est applicable à tout type de dispositif à encapsuler qui nécessite une protection vis-à-vis de l'atmosphère, et en particulier de l'humidité. Par exemple, le dispositif d'encapsulation selon la présente invention peut être utilisé pour encapsuler des cellules photovoltaïques organiques, des diodes électroluminescentes organiques (OLED : Organic Light-Emitting diode en terminologie anglaise), tout dispositif électronique, des microbatteries, des capteurs, des MEMS, des NEMS.

Le dispositif d'encapsulation selon la présente invention peut également être utilisé en sens inverse, c'est-à-dire pour éviter que le gaz contenu dans le dispositif d'encapsulation ne s'échappe, par exemple on pourrait réaliser un emballage pour boisson gazeuse avec le dispositif d'encapsulation selon la présente invention.

**Revendications**

1. Ensemble formé par un objet (4) reçu dans un dispositif d'encapsulation, ledit dispositif d'encapsulation comportant au moins une enveloppe (12) en matériau polymère souple remplie d'au moins un matériau hydrophobe liquide (14), ladite enveloppe délimitant un espace étanche recevant ledit objet (4), ledit objet (4) étant isolé du matériau hydrophobe (14).

2. Ensemble selon la revendication 1, dans lequel la au moins une enveloppe (12) comporte une première feuille (16.1) en polymère et une deuxième feuille (16.2) en polymère reliées l'une à l'autre au niveau de leurs bords extérieurs de sorte à définir un volume étanche au matériau hydrophobe entre les deux feuilles (16.1, 16.2).

3. Ensemble selon la revendication 1 ou 2, comportant deux enveloppes (12) en matériau polymère souple délimitant chacune un espace étanche au matériau hydrophobe, et au moins un matériau hydrophobe (14) remplissant chacune desdites enveloppes (12), lesdites enveloppes (12) étant superposées et reliées l'une à l'autre au niveau de leurs bords périphériques de manière étanche, un espace étanche (6) étant alors défini entre les deux enveloppes (12).

4. Ensemble selon l'une des revendications 1 à 3, dans lequel l'angle de contact d'une goutte de liquide du matériau hydrophobe (14) sur la surface intérieure de la au moins une enveloppe (12) est inférieur à 60°, de préférence l'angle de contact est inférieur à 30°, de manière préférée inférieur à 10°.

5. Ensemble selon la revendication 4, dans lequel l'énergie d'adhésion du matériau hydrophobe sous forme liquide sur la surface intérieure de l'enveloppe (12) est supérieure à 0,03 $J/m^2$, de manière préférée supérieure à 0,045 $J/m^2$.

6. Ensemble selon l'une des revendications 1 à 5, dans lequel le matériau hydrophobe (14) présente une solubilité de l'eau inférieure ou égale à $10^{-3}$ (fr.mol), avantageusement inférieure ou égale à $10^{-4}$ (fr.mol) (fr.mol étant la fraction molaire : le nombre de moles d'eau pouvant être solubilisé dans une mole de liquide hydrophobe).

**7.** Ensemble selon l'une des revendications 1 à 6, dans lequel le matériau hydrophobe (14) sous forme liquide présente une viscosité supérieure ou égale à $10^{-3}$ Pa.s.

**8.** Ensemble selon l'une des revendications 1 à 7, dans lequel le matériau hydrophobe (14) sous forme liquide confiné dans la au moins une enveloppe présente une épaisseur comprise entre 5 $\mu$m et 5 mm.

**9.** Ensemble selon l'une des revendications 1 à 8, dans lequel l'épaisseur de la paroi de au moins une enveloppe (12) est comprise entre 10 $\mu$m et 500 $\mu$m.

**10.** Ensemble selon l'une des revendications 1 à 9, dans lequel l'enveloppe(12) est réalisée en polycarbonate, en polyéthylène (PE), en polyéthylène téréphtalate (PET), en polyéthylène naphtalate (PEN), en copolymère éthylène-acétate de vinyle (EVA) ou en polyvinylalcool (PVA).

**11.** Ensemble selon l'une des revendications 1 à 10, dans lequel le matériau hydrophobe (14) est une huile minérale, une huile silicone, une huile paraffine, une huile naturelle, un acide gras ou un ester à longue chaîne alkyle, ou un alcane tel qu'un alcane des séries $C_{12}H_{26}$ à $C_{16}H_{34}$.

**12.** Ensemble selon l'une des revendications 1 à 11, l'objet (4) étant une cellule photovoltaïque ou une diode électroluminescente organique.

**13.** Procédé de réalisation d'un ensemble selon l'une des revendications 1 à 12, comportant la mise en place du ou des objets dans une enveloppe du dispositif d'encapsulation et de fermeture de manière étanche du dispositif d'encapsulation, par exemple par thermosoudage ou collage.

**14.** Procédé de réalisation selon la revendication 13, comportant les étapes de :

a) réalisation d'une enveloppe (12) en polymère souple dans laquelle est disposé le matériau hydrophobe (14)

b) scellement de l'enveloppe (12) de manière étanche.

**15.** Procédé de réalisation selon la revendication 14, dans lequel l'étape a) comprend la réalisation d'une enveloppe (12) en polymère souple munie d'une ouverture et le remplissage de l'enveloppe (12) avec un matériau hydrophobe (14).

**16.** Procédé de réalisation selon la revendication 15, dans lequel l'étape a) comporte la superposition de deux feuilles (16.1, 16.2) de polymère souple de tailles proches ou égales, de sorte que leurs bords périphériques soient sensiblement alignés et la solidarisation des bords périphériques de manière étanche sauf sur une portion, ménageant ainsi une ouverture de remplissage.

**17.** Procédé de réalisation selon la revendication 15 ou 16, dans lequel, préalablement à l'étape b), on recouvre au moins les bords de l'ouverture de remplissage d'un matériau oléophobe.

**18.** Procédé de réalisation selon la revendication 14, dans lequel, lors de l'étape a), on recouvre les bords d'une ou des feuilles (16.1, 16.2) de l'enveloppe (12) d'un matériau oléophobe, on enduit l'une des feuilles avec le matériau hydrophobe.

**19.** Procédé de réalisation selon la revendication 14, dans lequel, préalablement à l'étape a), le matériau hydrophobe (14), par exemple du tétradécane, est solidifié par abaissement de la température et mis en forme de bloc et, lors de l'étape a) l'enveloppe (12) est formée autour dudit bloc solide.

**Patentansprüche**

**1.** Einheit, gebildet durch einen Gegenstand (4), enthalten in einer Verkapselungsvorrichtung, wobei die genannte Verkapselungsvorrichtung wenigstens eine Hülle (12) aus einem nachgiebigen polymeren Material umfasst, gefüllt mit wenigstens einem flüssigen hydrophoben Stoff (14), und die genannte Hülle dabei einen den genannten Gegenstand (4) enthaltenden dichten Raum begrenzt, wobei der genannte Gegenstand (4) von dem hydrophoben Stoff (14) isoliert ist.

**2.** Einheit nach Anspruch 1, bei der die wenigstens eine Hülle (12) eine erste Folie (16.1) aus Polymer und eine zweite Folie (16.2) aus Polymer umfasst, miteinander verbunden an ihren äußeren Rändern, so dass sie für den hydrophoben Stoff zwischen den beiden Folien (16.1, 16.2) ein dichtes Volumen definieren.

**3.** Einheit nach Anspruch 1 oder 2, umfassend zwei Hüllen (12) aus nachgiebigem polymerem Material, jede einen Raum begrenzend, der dicht ist gegen den hydrophoben Stoff, und wenigstens einen, jede der genannten Hüllen (12) ausfüllenden, hydrophoben Stoff (14), wobei die genannten Hüllen (12) aufeinanderliegen und an ihren Umfangsrändern dicht miteinander verbunden sind, so dass die beiden Hüllen (12) zwischen sich einen dichten Raum (6) definieren.

**4.** Einheit nach einem der Ansprüche 1 bis 3, wobei der Kontaktwinkel eines Flüssigkeitstropfens des hydrophoben Stoffs (14) auf der Innenoberfläche wenigstens einer Hülle (12) kleiner als 60° ist, vorzugsweise kleiner als 30° ist, und am besten kleiner als 10° ist.

5. Einheit nach Anspruch 4, bei der die Adhäsionsenergie des hydrophoben Stoffs in flüssiger Form auf der Innenoberfläche der Hülle (12) größer als 0,03 J/m$^2$, vorzugsweise größer als 0,045 J/m$^2$ ist.

6. Einheit nach einem der Ansprüche 1 bis 5, bei der der hydrophobe Stoff (14) eine Wasserlöslichkeit kleiner oder gleich 10$^{-3}$ (mol.fr), vorzugsweise kleiner oder gleich 10$^{-4}$ (mol.fr) aufweist (wobei mol.fr die Molfraktion ist: die Anzahl Wassermole, die in einem Mol hydrophober Flüssigkeit gelöst werden können).

7. Einheit nach einem der Ansprüche 1 bis 6, bei der der hydrophobe Stoff (14) in flüssiger Form eine Viskosität größer oder gleich 10$^{-3}$ Pa.s aufweist.

8. Einheit nach einem der Ansprüche 1 bis 7, bei der der in der wenigstens einen Hülle eingeschlossene hydrophobe Stoff (14) in flüssiger Form eine zwischen 5 $\mu$m und 5 mm enthaltene Dicke aufweist.

9. Einheit nach einem der Ansprüche 1 bis 8, bei der die Dicke der Wand von wenigstens einer Hülle (12) zwischen 10 $\mu$m und 500 $\mu$m enthalten ist.

10. Einheit nach einem der Ansprüche 1 bis 9, bei dem die Hülle (12) aus Polycarbonat, aus Polyethylen (PE), aus Polyethylenterephthalat (PET), aus Polyethylennaphthalat (PEN), aus Ethylen-Vinylacetat-Copolymer (EVA) oder aus Polyvinylalkohol (PVA) ist.

11. Einheit nach einem der Ansprüche 1 bis 10, bei der der hydrophobe Stoff (14) ein Mineralöl, ein Silikonöl, ein Paraffinöl, ein natürliches Öl, eine Fettsäure oder ein Ester mit langer Alkylkette, oder ein Alkan wie etwa ein Alkan der Serien $C_{12}H_{26}$ bis $C_{16}H_{34}$ ist.

12. Einheit nach einem der Ansprüche 1 bis 11, wobei der Gegenstand (4) eine photovoltaische Zelle oder eine organische elektrolumineszente Diode ist.

13. Herstellungsverfahren einer Einheit nach einem der Ansprüche 1 bis 12, umfassend das Einsetzen des oder der Gegenstände in eine Hülle der Verkapselungsvorrichtung und das dichte Verschließen der Verkapselungsvorrichtung, zum Beispiel durch Thermoschweißung oder Klebung.

14. Herstellungsverfahren nach Anspruch 13, die folgenden Schritte umfassend :

a) Herstellung einer Hülle (12) aus weichem Polymer, die mit dem hydrophoben Stoff (14) gefüllt wird.

b) Verschließen der Hülle (12) auf dichte Weise.

15. Herstellungsverfahren nach Anspruch 14, bei dem der Schritt a) das Herstellen einer Hülle (12) aus weichem Polymer, versehen mit einer Öffnung, und das Befüllen der Hülle (12) mit einem hydrophoben Stoff (14) umfasst.

16. Herstellungsverfahren nach Anspruch 15, bei dem der Schritt a) das Aufeinanderlegen der beiden gleich oder ähnlich großen Folien (16.1, 16.2) aus weichem Polymer umfasst, so dass ihre Umfangsränder im Wesentlichen bündig sind und die feste Verbindung der Umfangsränder dicht ist, außer in einem Teilstück, das auf diese Weise eine Befüllungsöffnung bildet.

17. Herstellungsverfahren nach Anspruch 15 oder 16, bei dem man - vor dem Schritt b) - wenigstens die Ränder der Befüllungsöffnung mit einem ölabweisenden Stoff überzieht.

18. Herstellungsverfahren nach Anspruch 14, bei dem man während des Schritts a) die Ränder der - oder einer der - Folien (16.1, 16.2) der Hülle (12) mit einem ölabweisenden Stoff überzieht, man eine der Folien mit dem hydrophoben Stoff bestreicht bzw. beschichtet.

19. Herstellungsverfahren nach Anspruch 14, bei dem man während des Schritts a) den hydrophoben Stoff (14), zum Beispiel Tetradecan, durch Temperaturabsenkung zu einem Block erstarren lässt und man in dem Schritt a) die Hülle (12) um den genannten festen Block herum formt.

**Claims**

1. Assembly formed of an object (4) received in an encapsulation device, said encapsulation device comprising at least one casing (4) made of a flexible polymer material filled with at least one liquid hydrophobic material (14), said casing delimiting a sealed space receiving said object (4), said object (4) being isolated from the hydrophobic material (14).

2. Assembly according to claim 1, wherein the at least one casing (12) comprises a first polymer sheet (16.1) and a second polymer sheet (16.2) interconnected at the exterior edges thereof so as to define a sealed volume to the hydrophobic material between the two sheets (16.1, 16.2).

3. Assembly according to claim 1 or 2, comprising two casings (12) made of a flexible polymer material each delimiting a sealed space to the hydrophobic material, and at least one hydrophobic material (14) filling each of said casings (12), said casings (12) being stacked and sealingly interconnected at the peripheral edges thereof, a sealed space (6) then being defined between the two casings (12).

4. Assembly according to one of claims 1 to 3, wherein the contact angle of a drop of liquid of the hydrophobic material (14) on the inner surface of the at least one casing (12) is less than 60, preferably the contact angle is less than 30°, in a preferred manner less than 10°.

5. Assembly according to claim 4, wherein the adhesion energy of the hydrophobic material in liquid form on the inner surface of the casing (12) is greater than 0.03 $J/m^2$, in a preferred manner greater than 0.045 $J/m^2$.

6. Assembly according to one of claims 1 to 5, wherein the hydrophobic material (14) has a water solubility less than or equal to $10^{-3}$ (fr.mol), advantageously less than or equal to $10^{-4}$ (fr.mol) (fr.mol being the molar fraction : the number of water moles that can be solubilised in one mole of hydrophobic liquid).

7. Assembly according to one of claims 1 to 6, wherein the hydrophobic material (14) in liquid form has a viscosity greater than or equal to $10^{-3}$ Pa.s.

8. Assembly according to one of claims 1 to 7, wherein the hydrophobic material (14) in liquid form confined in the at least one casing has a thickness comprised between 5 $\mu$m and 5 mm.

9. Assembly according to one of claims 1 to 8, wherein the thickness of the wall of at least one casing (12) is comprised between 10 $\mu$m and 500 $\mu$m.

10. Assembly according to one of claims 1 to 9, wherein the casing (12) is made of polycarbonate, polyethylene (PE), polyethylene terephthalate (PET), polyethylene naphthalate (PEN), ethyl vinyl acetate (EVA) copolymer or polyvinyl alcohol (PVA).

11. Assembly according to one of claims 1 to 10, wherein the hydrophobic material (14) is a mineral oil, a silicone oil, a paraffin oil, a natural oil, a fatty acid or long alkyl chain ester, or an alkane such as an alkane of the series $C_{12}H_{26}$ to $C_{16}H_{34}$.

12. Assembly according to one of claims 1 to 11, the object (4) being a photovoltaic cell or an organic light emitting diode.

13. Method of producing an assembly according to one of claims 1 to 12 comprising the placing of the object(s) in a casing of the encapsulation device and the closing in a sealed manner of the encapsulation device, for example by heat sealing or bonding.

14. Method of production according to claim 13, comprising the steps of:

   a) forming a casing (12) made of flexible polymer wherein is placed the hydrophobic material (14)
   b) sealing of the casing (12) in a sealed manner.

15. Method of production according to claim 14, wherein step a) comprises the production of a casing (12) made of flexible polymer provided with an opening and the filling of the casing (12) with a hydrophobic material (14).

16. Method of production according to claim 15, wherein step a) comprises the stacking of two sheets (16.1, 16.2) of flexible polymer of similar or equal sizes, such that their peripheral edges are substantially aligned, and the joining of the peripheral edges in a sealed manner except on one portion, thereby arranging a filling opening.

17. Method of production according to claim 15 or 16, wherein, prior to step b), at least the edges of the filling opening are covered with an oleophobic material.

18. Method of production according to claim 14, wherein, during step a), the edges of one or more sheets (16.1, 16.2) of the casing (12) are covered with an oleophobic material, one of the sheets is coated with the hydrophobic material.

19. Method of production according to claim 14, wherein, prior to step a), the hydrophobic material (14), for example tetradecane is solidified by lowering the temperature and shaping into a block and, during step a) the casing (12) is formed around said solid block.

FIG. 1

FIG. 2

FIG. 3A

FIG. 3B

8.1

14

# FIG. 4

12

4

14

# FIG. 5

8.1

8.2

14

# FIG. 6

## RÉFÉRENCES CITÉES DANS LA DESCRIPTION

**Documents brevets cités dans la description**

- US 5272856 A

**Littérature non-brevet citée dans la description**

- **KREBS F. et al.** *Solar Energy Materials and Solar Cells,* 2006, vol. 90, 3633-3643

- **BURROWS P.** Ultra Barrier flexible Susbstrates for flat panel displays. *Displays,* 2001, vol. 22, 65-69